(19) Europäisches Patentamt

European Patent Office

Office européen des brevets

(11) Veröffentlichungsnummer: **0 281 926 B1**

(12) **EUROPÄISCHE PATENTSCHRIFT**

(45) Veröffentlichungstag der Patentschrift: **09.10.91**

(21) Anmeldenummer: **88103210.6**

(22) Anmeldetag: **02.03.88**

(51) Int. Cl.⁵: **H01R 9/09**

(54) **Steckfassung.**

(30) Priorität: **11.03.87 DE 3707861**

(43) Veröffentlichungstag der Anmeldung:
**14.09.88 Patentblatt 88/37**

(45) Bekanntmachung des Hinweises auf die
Patenterteilung:
**09.10.91 Patentblatt 91/41**

(84) Benannte Vertragsstaaten:
**BE CH DE FR GB IT LI SE**

(56) Entgegenhaltungen:
**WO-A-84/03653**
**FR-A- 1 550 773**
**FR-A- 2 542 964**

**RCA - TECHNICAL NOTES, Nr. 842, 24. Juli
1969, Seiten 1-4, Princeton, New Jersey, US;
F.S. BARKALOW et al.: "High temperature
connecting plug"**

(73) Patentinhaber: **SIEMENS AKTIENGESELL-
SCHAFT**
**Wittelsbacherplatz 2**
**W-8000 München 2(DE)**

(72) Erfinder: **Esterl, Robert**
**Reinstorf 10**
**W-8019 Glonn(DE)**
Erfinder: **Weiser, Josef, Dr.rer.nat.**
**Benediktstrasse 11**
**W-8021 Hohenschäftlarn(DE)**

## Beschreibung

Die Erfindung betrifft eine Steckfassung zur Aufnahme von Anschlußelementen eines Bauelementes, insbesondere eines Relais, zum Einsatz auf Leiterplatten, mit einem flachen Trägerkörper aus temperaturfestem Isolierstoff und mit im Trägerkörper ausgebildeten, zur Oberseite des Trägerkörpers offene Einstecköffnungen aufweisenden Kammern, wobei in den Kammern jeweils Fassungsfedern angeordnet sind, welche jeweils mindestens einen quer zur Einsteckrichtung elastisch nachgebenden Kontaktschenkel und je mindestens ein zur Unterseite des Trägerkörpers durchgeführtes Lötanschlußelement aufweisen.

Eine derartige Steckfassung ist beispielsweise in der DE-OS 16 14 401 beschrieben. Solche Steckfassungen dienten in der Vergangenheit dazu, einen nachträglichen Austausch zur Reparatur oder zum Ersatz des eingesteckten Bauelementes zu ermöglichen. Die Kammern mit den Fassungsfedern waren dabei in der Regel zur Oberseite und meist auch zur Unterseite offen. Um ein leichtes Einstecken und Herausziehen des Bauelementes zu ermöglichen, waren die Kontaktschenkel in den Fassungskammern zu dem einzusteckenden Anschlußstift hin beiderseitig bogenförmig geformt, so daß in keinem Fall eine scharfe Kante an den einzusteckenden Anschlußstift geriet, die eine gegenseitige Verletzung der Kontaktoberflächen bewirkt hätte.

In der Leiterplattentechnik ist allerdings die Verwendung von derartigen Steckfassungen nicht üblich. Vielmehr werden Bauelemente, wie Relais, in der Regel unmittelbar mit ihren Anschlußstiften in die Leiterplatte eingesetzt und mit den übrigen Bauelementen von der Rückseite her durch Schwallötung kontaktiert.

Dies hat den Vorteil einer geringeren Bauhöhe und geringerer Übergangswiderstände.

Probleme ergaben sich allerdings in neuerer Zeit durch die immer stärkere Verbreitung der Oberflächenmontagetechnik (allgemein als SMD-Technik oder SMT bekannt), bei der die Bauelemente mit Flachkontakten nur auf eine Seite der nicht durchbohrten Leiterplatte aufgesetzt und unmittelbar verlötet werden. Neben vielen Vorteilen, etwa der einfacheren Bestückung, bringt diese Technik jedoch eine hohe Temperaturbelastung für die Bauteile mit sich, da diese unmittelbar durch das Lötbad geführt werden. Auf diese Weise werden die Bauteile je nach dem angewendeten Verfahren mit Temperaturen bis 270° C belastet, wobei diese Temperaturbelastung nur beim Einlöten, nicht aber im späteren Einsatz, auftritt. Kunststoffgehäuse für Relais sind aber in der Regel bisher für solche Temperaturbelastungen nicht ausgelegt, sie müßten also in kostenträchtiger Weise nur für die Montage neu konzipiert werden. Viele bestehende Relaistypen, die für eine solche Belastung nicht ausgelegt sind, könnten außerdem in derartig verarbeiteten Leiterplatten nicht eingesetzt werden.

Aufgabe der Erfindung ist es, eine Steckfassung der eingangs genannten Art zu schaffen, die auf Leiterplatten in beliebiger Weise eingesetzt werden kann, insbesondere auch in Oberflächenmontagetechnik durch ein Lötbad geführt werden kann und die es zugleich gestattet, nach dem Löten der Leiterplatte das betreffende Bauelement auf einfache Weise einzusetzen und in zufriedenstellender Weise zu kontaktieren.

Erfindungsgemäß wird diese Aufgabe mit der genannten Steckfassung dadurch gelöst, daß die Oberseite des aus temperaturfestem Material bestehenden Trägerkörpers mit einer die Einstecköffnungen verschließenden Abdeckfolie aus temperaturfestem, elastischem Isoliermaterial bedeckt ist.

Durch die erfindungsgemäße Abdeckung der Fassungskammern der Steckfassung mit einer elastischen Folie oder Membran wird gewährleistet, daß die auf einer Leiterplatte, insbesondere in SMD-Technik, eingesetzte Steckfassung in beliebiger Weise auch durch ein Lötbad geführt werden kann. Nach dem Löten kann dann das Bauelement, also insbesondere das Relais, in die Steckfassung eingesetzt werden, wobei die Folie durch die Anschlußstifte des Bauelementes durchstochen wird. Unter Umständen kann die Folie oder Membran im Bereich der Einstecköffnungen eine verringerte Wandstärke aufweisen.

Wenn die Fassungsfedern mit ihren Lötanschlüssen bereits dicht zur Unterseite der Steckfassung herausgeführt sind, etwa bei eingebetteten Fassungsfedern oder auch bei nachträglicher Abdichtung der Durchführungen, genügt es, die Steckfassung an der Oberseite mit der genannten Abdeckfolie zu überziehen. Meist werden jedoch die Fassungsfedern in entsprechende Durchbrüche eingesteckt. In diesem Fall ist es zweckmäßig, auch die Unterseite des Trägerkörpers mit einer die Durchführungen der Lötanschlußelemente abdichtenden Folie zu bedecken.

In einer vorteilhaften Ausgestaltung ist weiterhin vorgesehen, daß die Kontaktschenkel der Fassungsfedern in Form von Widerhaken schräg zur Einsteckrichtung verlaufen und gegenüber einem eingesteckten Anschlußelement scharfe Abschlußkanten aufweisen. Da diese Steckfassung nur für eine einmalige Bestückung mit dem betreffenden Bauelement gedacht ist, ist es nicht nur tragbar, sondern sogar erwünscht, daß die Fassungsfedern mit scharfen Kanten die Oberflächen der eingesteckten Anschlußelemente gut reinigen und sich mit ihnen verbinden, eventuell sogar kaltverschweißen. Durch entsprechende Gestaltung der Fassungsfedern mit ihren Kontaktschenkeln kann ein hoher Kontaktdruck mit einer guten mechanischen Festigkeit erzeugt werden.

Die Lötanschlußelemente könnten natürlich auch bei dieser Steckfassung als geradlinige Stifte ausgebildet und in herkömmlicher Weise in Bohrungen der Leiterplatte eingesteckt werden. Der besondere Vorteil der erfindungsgemäßen Steckfassung liegt jedoch in der Anwendung bei der Oberflächenmontagetechnik, wobei die Lötanschlußelemente jeweils unterhalb des Trägerkörpers senkrecht zur Steckrichtung abgebogen sind, also flach auf der Leiterplatte aufliegen.

Die Erfindung wird nachfolgend an Ausführungsbeispielen anhand der Zeichnung näher erläutert. Es zeigen

FIG 1 bis 4 jeweils einen Querschnitt durch einen Teil einer Steckfassung mit einer Fassungskammer und verschiedenen Formen von Fassungsfedern,

FIG 5 und 6 jeweils eine Steckfassung in perspektivischer Ansicht mit unterschiedlich gestalteten SMT-Anschlußelementen.

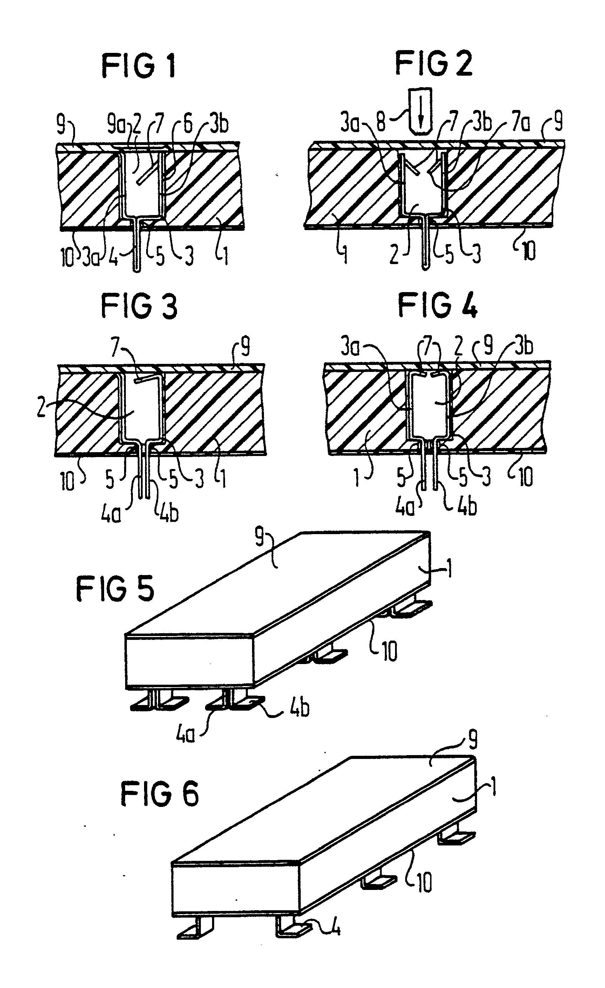

In den FIG 1 bis 4 ist jeweils ein Teilschnitt aus einer Steckfassung gezeigt, wobei in einem plattenförmigen Trägerkörper 1 aus temperaturfestem Kunststoff Fassungskammern 2 eingeformt sind (es ist jeweils nur eine Kammer dargestellt). In diese Kammern 2 sind jeweils Fassungsfedern 3 eingesetzt, und zwar sind sie mit ihren angeformten Lötanschlußelementen 4 in Durchbrüche 5 im Bereich der Unterseite des Trägerkörpers 1 eingesteckt. Die Fassungsfedern 3 besitzen jeweils zwei Federschenkel 3a und 3b, die sich etwa längs der Seitenwände der Kammern 2 erstrecken, jedoch gegenüber diesen Seitenwänden ein geringes Spiel 6 aufweisen können. Sie können ein einziges, eventuell gefaltetes Lötanschlußelement 4 gemäß FIG 1 oder 2 aufweisen oder gemäß FIG 3 und 4 zwei getrennte Lötanschlußelemente 4a und 4b besitzen, die dann in jeweils eigene Durchführungen 5 eingesteckt sind.

An einem Federschenkel (FIG 1 und 3) oder an beiden Federschenkeln (FIG 2 und 4) ist jeweils ein Kontaktschenkel 7 aus dem Mittelbereich herausgebogen (FIG 1 und 2) oder am freien Ende abgebogen (FIG 3 und 4). Diese Kontaktschenkel 7 stehen schräg zur Einsteckrichtung eines Bauteileanschlußelementes 8, wie es in FIG 2 angedeutet ist. Dadurch reiben die scharfen Abschlußkanten 7a an der Oberfläche des Anschlußelementes 8. Dadurch wird die spätere Kontaktstelle des verzinnten Anschlußelementes 8 beim Stecken gut gereinigt und unter Umständen sogar kaltverschweißt. Die Federschneide dringt dabei zum Teil durch Eigenerschütterung der Bauteile in das weiche Zinn ein, womit die eigentliche statische Kontaktstelle abgedichtet wird. Das beschriebene Widerhakenprinzip der Kontaktschenkel 7 ergibt auch eine gute mechanische Festigkeit der Kontaktierung mit hohem Flächendruck. Die Kontaktierung ist vorzugsweise doppelt oder mehrfach.

Die in die FIG 1 bis 4 gezeigten Fassungsfederformen können natürlich in beliebiger Weise untereinander kombiniert werden. Alle diese Federformen können in Kammform hergestellt und ausgeformt werden; anschließend werden sie mit geeigneten Kontaktschichten galvanisch beschichtet und vom Kamm aus in die Kammern 2 hinein rastend bestückt.

Wesentlich für die Erfindung ist aber, daß auf der Oberseite des Trägerkörpers 1 jeweils eine elastische, temperaturfeste Membran oder Abdeckfolie 9 aufgelegt, aufgeklebt oder aufvulkanisiert ist. Geeignete Werkstoffe hierfür sind beispielsweise Silikonkautschuk, fluorhaltige Polymere (z. B. Polytetrafluoräthylen), Fluorelastomere oder andere Folien. Diese Folie oder Membran 9 dichtet zunächst die Steckfassung an der Oberseite völlig ab, so daß die Fassung nach dem Einlöten in die Leiterplatte mit dieser auch waschbar ist. Später wird die Folie 9 durch die Anschlußelemente 8 des einzusteckenden Bauelementes durchstochen. In den Bereich über der jeweiligen Fassungskammer 2 kann eine geringere Wandstärke 9a vorgesehen sein, wie in FIG 1 angedeutet. Nach dem Einstecken des Anschlußelementes 8 dichtet die Membran infolge ihrer Elastizität die Kammer ab.

Beim Einstecken eines Anschlußelementes 8 gibt die Fassungsfeder 3 zunächst nach, soweit das Spiel 6 es gestattet. Dadurch ergibt sich zunächst eine weiche Federcharakteristik. Im weiteren Verlauf stützt sich die Fassungsfeder aber an der Wand der Kammer 2 ab; durch die harte Federcharakteristik des Schenkels 7 baut sich eine hohe Kontaktkraft auf. Falls beim Einstecken des Bauelementes Partikel der Folie 9 mitgerissen würden, werden diese durch die Steckreibung an den Kontaktschenkeln 7 abgestreift und beeinflussen nicht die Zuverlässigkeit der Kontaktierung.

Beim gezeigten Ausführungsbeispiel ist auch die Unterseite des Trägerkörpers 1 mit einer Folie 10 beschichtet. Dadurch werden auch die Durchbrüche 5 für die Lötanschlußelemente 4 abgedichtet. Es wäre aber auch eine andere Abdichtungsmöglichkeit denkbar.

Die beschriebenen Folien sind auch nach dem Einstecken des Bauelementes noch von Vorteil. Zum einen bringen sie eine gute zusätzliche Abdichtung der Kontaktstellen gegenüber äußeren Schadgasen. Zum anderen bewirken sie infolge ihrer Elastizität eine mechanische Dämpfung gegenüber Erschütterungen, so daß die gesteckten Bauelemente sozusagen elastisch eingespannt sind.

Die Kontaktschichten auf den Federelementen, insbesondere auf den Kontaktschenkeln 7, bestehen vorzugsweise aus lokal aufgebrachten galvanischen Sandwichschichten aus Pd + Au, PdNi + Au, PdAg + Au und ähnlichen Legierungen.

Die FIG 5 und 6 zeigen jeweils Gesamtansichten von Fassungen mit jeweils einem Trägerkörper 1, den Folien 9 und 10 und den nach unten herausgeführten Lötanschlußelementen für Oberflächenmontage. Bei dem Beispiel von FIG 5 sind die doppelt herausgeführten Lötanschlußelemente 4a und 4b entgegengesetzt zueinander abgebogen, während beim Beispiel von FIG 6 jeweils ein einziges Lötanschlußelement 4 nach außen abgebogen ist. Lediglich der Vollständigkeit halber sei noch erwähnt, daß als Material für den Trägerkörper 1 beliebige temperaturfeste Kunststoffe Verwendung finden können, beispielsweise Thermoplaste, wie PPS, PBTP und ähnliche oder auch Duroplaste.

## Patentansprüche

1. Steckfassung zur Aufnahme von Anschlußelementen eines Bauelementes, insbesondere eines Relais, zum Einsatz auf Leiterplatten, mit einem flachen Trägerkörper (1) aus temperaturfestem Isolierstoff und mit im Trägerkörper ausgebildeten, zur Oberseite des Trägerkörpers offene Einstecköffnungen aufweisenden Kammern (2), wobei in den Kammern jeweils Fassungsfedern (3) angeordnet sind, welche jeweils mindestens einen quer zur Einsteckrichtung elastisch nachgebenden Kontaktschenkel (7) und je mindestens ein zur Unterseite des Trägerkörpers durchgeführtes Lötanschlußelement (4) aufweisen, **dadurch gekennzeichnet**, daß die Oberseite des aus temperaturfestem Material bestehenden Trägerkörpers (1) mit einer die Einstecköffnungen verschließenden Abdeckfolie (9) aus temperaturfestem, elastischem Isoliermaterial bedeckt ist.

2. Steckfassung nach Anspruch 1, **dadurch gekennzeichnet**, daß zusätzlich die Unterseite des Trägerkörpers (1) mit einer die Durchführungen der Lötanschlußelemente (4) abdichtenden Folie (10) bedeckt ist.

3. Steckfassung nach Anspruch 1 oder 2, **dadurch gekennzeichnet**, daß die oberseitige Abdeckfolie (9) im Bereich der Einstecköffnungen jeweils eine verringerte Wandstärke (9a) aufweist.

4. Steckfassung nach einem der Ansprüche 1 bis 3, **dadurch gekennzeichnet**, daß die Kontaktschenkel (7) der Fassungsfedern in Form von Widerhaken schräg zur Einsteckrichtung verlaufen und gegenüber einem eingesteckten Anschlußelement (8) scharfe Abschlußkanten (7a) aufweisen.

5. Steckfassung nach einem der Ansprüche 1 bis 4, **dadurch gekennzeichnet**, daß die Kontaktschenkel (7) jeweils nur im Bereich ihrer Abschlußkanten mit edlem Kontaktmaterial beschichtet sind.

6. Steckfassung nach einem der Ansprüche 1 bis 5, **dadurch gekennzeichnet**, daß die Fassungsfedern (3) jeweils an einem weichen Federschenkel (3a, 3b) den Kontaktschenkel (7) tragen, derart, daß sich die Kontaktschenkel nach einem kurzen Weg aus der Ruhelage mit weicher Federcharakteristik an der jeweiligen Kammerwand abstützen und eine harte Federcharakteristik zur Wirkung bringen.

7. Steckfassung nach einem der Ansprüche 1 bis 6, **dadurch gekennzeichnet**, daß die Lötanschlußelemente (4; 4a, 4b) jeweils unterhalb des Trägerkörpers (1) senkrecht zur Steckrichtung abgebogen sind.

## Claims

1. Plug-in mounting for holding the connecting elements of a component, preferably a relay, for insertion on printed circuit boards, having a flat base (1) of temperature-resistant dielectric and having chambers (2), constructed in the base, and having insertion openings open towards the upper side of the base, mounting springs (6) being arranged in each of the chambers, which springs each have at least one contact arm (7), moving elastically transversely to the direction of insertion, and each have at least one solder connection element (4) fed through to the underside of the base, characterised in that the upper side of the base (1), consisting of temperature-resistant material, is coated with a covering film (9), of temperature-resistant, elastic dielectric material, sealing the insertion openings.

2. Plug-in mounting according to Claim 1, characterised in that, in addition, the underside of the base (1) is coated with a film (10) sealing the feed-throughs of the solder connection elements (4).

3. Plug-in mounting according to Claim 1 or 2, characterised in that the covering film (9) on the upper side has a reduced wall thickness (9a) in the region of each of the insertion openings.

4. Plug-in mounting according to one of Claims 1 to 3, characterised in that the contact arms (7) of the mounting springs run in the form of barbs at an angle to the direction of insertion, and have sharp sealing edges (7a) with respect to an inserted connecting element (8).

5. Plug-in mounting according to one of Claims 1 to 4, characterised in that the contact arms (7) are each coated with a noble contact material only in the region of their sealing edges.

6. Plug-in mounting according to one of Claims 1 to 5, characterised in that the mounting springs (3) in each case carry the contact arm (7) on a soft spring arm (3a, 3b), in such a manner that, after a short movement from their rest position having a soft spring characteristic, the contact arms support themselves on the respective chamber wall and bring into effect a hard spring characteristic.

7. Plug-in mounting according to one of Claims 1 to 6, characterised in that the solder connection elements (4; 4a, 4b) are in each case bent underneath the base (1) perpendicular to the direction of insertion.

**Revendications**

1. Support d'enfichage destiné à loger des éléments de raccordement d'un composant, notamment un relais, pour son utilisation sur des plaquettes à circuits imprimés, comportant un corps de support plat (1) formé d'un matériau résistant à la température, et des chambres (2) qui sont ménagées dans le corps de support et comportent des ouvertures d'enfichage ouvertes en direction de la face supérieure du corps de support et dans lesquelles sont disposés respectivement des ressorts de support (3), qui possèdent respectivement au moins une branche de contact (7), qui fléchit élastiquement transversalement par rapport à la direction d'enfichage, et respectivement au moins un élément formant cosse à souder (4) traversant le corps de support en direction de sa face inférieure, caractérisé par le fait que la face supérieure du corps de support (1) réalisé en un matériau résistant à la température, est recouverte par une feuille de revêtement (9), qui ferme les ouvertures d'enfichage et qui est réalisée en un matériau isolant élastique résistant à la température.

2. Support d'enfichage suivant la revendication 1, caractérisé par le fait que la face inférieure du corps de support (1) est recouverte, en supplément, d'une feuille (10) fermant de façon étanche les traversées des éléments formant cosses à souder (4).

3. Support d'enfichage suivant la revendication 1 ou 2, caractérisé par le fait que la feuille de revêtement (9), située au niveau de la face supérieure, possède une épaisseur de paroi réduite (9a) dans la zone des ouvertures d'enfichage.

4. Support d'enfichage suivant l'une des revendications 1 à 3, caractérisé par le fait que les branches de contact (7) des ressorts de support possèdent la forme de crochets s'étendant obliquement par rapport à la direction d'enfichage et possèdent des arêtes terminales (7a) en forme d'arêtes vives en vis-à-vis d'un élément de raccordement (8) enfiché.

5. Support d'enfichage suivant l'une des revendications 1 à 4, caractérisé par le fait que les branches de contact (7) sont recouvertes d'un matériau de contact noble uniquement dans la zone de leurs arêtes terminales.

6. Support d'enfichage suivant l'une des revendications 1 à 5, caractérisé par le fait que les ressorts de support (3) supportent respectivement, au niveau d'une branche molle (3a,3b) du ressort, la branche de contact (7) de sorte que les branches de contact prennent appui sur la paroi respective de la chambre, après une brève course de déplacement à partir de la position de repos, avec une caractéristique de ressort mou, et font apparaître une caractéristique de ressort dur.

7. Support d'enfichage suivant l'une des revendications 1 à 6, caractérisé par le fait que les éléments formant cosses à souder (4;4a,4b) sont repliés respectivement au-dessous du corps de support (1), perpendiculairement à la direction d'enfichage.

# FIG 1

# FIG 2

# FIG 3

# FIG 4

# FIG 5

# FIG 6